# DEMANDE DE BREVET EUROPEEN

(11) **EP 1 229 647 A1**
(43) Date de publication de la demande: **07.08.2002**
(21) Numéro de dépôt: 02290167.2
(22) Date de dépôt: 23.01.2002
(51) Int. Cl.: H03K 17/96

(54) **Organe de commande capacitif pour un organe fonctionnel notamment de véhicule automobile, et pièce d'équipement comportant un tel organe**

(30) Priorité: 26.01.2001 FR 0101118; 10.04.2001 FR 0104898
(71) Demandeur: Faurecia Industries, 92100 Boulogne (FR)
(72) Inventeur: Galmiche, Etienne, 25460 - Etupes (FR); Bocquet, Denis, 90850 - Essert (FR)
(74) Mandataire: Habasque, Etienne Joel Jean-François

(57) **Abrégé**

Cet organe de commande de type capacitif pour la commande d'au moins un organe fonctionnel notamment de véhicule automobile, comprenant une structure de support rigide (4), au moins une cellule capacitive de détection tactile (7) localisée sur ou à proximité d'une des faces de ladite structure de support et au moins une zone (5) d'opération de commande localisée sur ou à proximité de l'autre face de ladite structure de support (4) en regard de ladite cellule capacitive de détection tactile (7), est caractérisé en ce que la zone d'opération de commande comprend des moyens (10,11) déformables élastiquement.

## Description

La présente invention concerne un organe de commande de type capacitif pour la commande d'au moins un organe fonctionnel notamment de véhicule automobile et une pièce d'équipement de véhicule, comportant un tel organe.

On sait que les pièces d'équipement des véhicules automobiles intègrent en nombre croissant des organes de commande des organes fonctionnels de ces véhicules.

Plusieurs pièces d'équipement disposées dans l'habitacle d'un véhicule reçoivent en effet des organes de commande de ce type, qui sont alors mis à la disposition des utilisateurs du véhicule.

Ces pièces sont par exemple formées par les panneaux de porte, la planche de bord ou encore la console centrale du véhicule, etc...

Ces organes de commande sont en général regroupés sur ce que l'on appelle communément des platines qui regroupent différents organes, tels que par exemple des interrupteurs, des commutateurs ou encore des boutons rotatifs intégrés dans les circuits électriques de commande des organes fonctionnels.

Mais l'on conçoit que ces organes présentent un certain nombre d'inconvénients, notamment au niveau de leur encombrement et de leur fiabilité, car ceux-ci mettent en jeu des pièces en mouvement.

Un autre problème lié à l'utilisation de ce type d'organes, réside dans la complexité de leur montage et de leur implantation à bord du véhicule qui nécessite l'utilisation de pièces de fixation (vis, platine, etc ..) et un temps de montage relativement long.

On connaît par ailleurs de façon générale, les détecteurs tactiles.

On pourra par exemple se reporter aux documents FR-A-2 779 889, FR-A-2 737 359, US-A-5 572 205 et US-A-5 270 710.

Le principe de fonctionnement de ces détecteurs consiste à détecter une variation de capacité grâce à une électrode placée par exemple sur une plaque de circuit imprimé sous une zone d'opération de commande, cette variation de capacité étant ensuite analysée et traitée par un circuit électronique permettant de commander une fonction quelconque.

Ces détecteurs présentent l'avantage de ne pas nécessiter de pièces en mouvement, mais ils présentent un inconvénient au niveau du retour d'information en particulier tactile vers l'utilisateur.

Ainsi par exemple, avec un système à touches sensitives, tel que décrit dans le document US-A-5 572 205, dans lequel il est prévu un support rigide avec un capteur capacitif sur une face du support et une zone d'opération en regard sur l'autre face de ce support, la sensation d'appuyer sur un bouton n'est pas perçue par l'utilisateur.

Ceci peut être gênant par exemple si l'utilisateur est le conducteur du véhicule qui appuie alors en aveugle sur les organes de commande.

Sans retour d'information tactile, cet utilisateur peut alors être amené à appuyer plusieurs fois sur la zone d'opération au risque de ne pas obtenir la commande souhaitée.

En outre, cela occasionne un problème de concentration sur la conduite du véhicule.

Le document US-A-4 022 296 décrit quant à lui, un boîtier de commande comprenant des interrupteurs de commande capacitifs qui posent également de tels problèmes.

Le but de l'invention est donc de résoudre ces problèmes.

A cet effet, l'invention a pour objet un organe de commande de type capacitif pour la commande d'au moins un organe fonctionnel notamment de véhicule automobile, comprenant une structure de support rigide, au moins une cellule capacitive de détection tactile localisée sur ou à proximité d'une des faces de ladite structure de support et au moins une zone d'opération de commande localisée sur ou à proximité de l'autre face de ladite structure de support en regard de ladite cellule capacitive de détection tactile, caractérisé en ce que la zone d'opération de commande comprend des moyens déformables élastiquement.

Selon d'autres caractéristiques :
- les moyens déformables élastiquement sont indépendants de la commande de l'organe fonctionnel ;
- les moyens déformables élastiquement ont une position de repos dans laquelle le doigt de l'opérateur au contact de la zone d'opération est hors de l'espace de détection tactile et une position déformée dans laquelle le doigt de l'opérateur au contact de la zone d'opération est dans l'espace de détection tactile ;
- les moyens déformables élastiquement sont formés par une partie en saillie d'une pièce intermédiaire en matériau déformable élastiquement, fixée sous la structure de support ;
- la structure de support rigide porte une plaque de circuit imprimé sur laquelle sont fixées la cellule capacitive et une source lumineuse ;
- la pièce intermédiaire porte une plaque de circuit imprimé sur laquelle sont fixées la cellule capacitive et une source lumineuse ;
- un masque matérialisant un pictogramme associé à la fonction commandée par celui-ci, est associé à la pièce intermédiaire ou à la plaque de circuit imprimé ;
- la zone d'opération de commande est matérialisée par une portion en relief de la structure de support ;
- la pièce intermédiaire et la plaque de circuit imprimé sont en matériau translucide et la source lumineuse est fixée sous la plaque de circuit imprimé.

Selon un autre aspect, l'invention a également pour objet une pièce d'équipement de véhicule automobile équipée d'au moins un organe de commande d'un organe fonctionnel, tel que défini précédemment.

Selon d'autres caractéristiques :
- elle comporte une structure de support sur laquelle est disposée une peau de revêtement souple et translucide et la structure de support comporte au moins une lumière sous laquelle sont placés des moyens formant détecteur tactile et une source lumineuse ;
- les moyens formant détecteur tactile sont portés par une plaque de circuit imprimé translucide sous laquelle est fixée la source lumineuse ;
- la peau de revêtement porte un masque matérialisant un pictogramme associé à la fonction commandée par l'organe ;
- le circuit imprimé porte un masque matérialisant un pictogramme associé à la fonction commandée par l'organe ;
- la lumière de la structure de support présenté une forme matérialisant un pictogramme associé à la fonction commandée par l'organe ;
- la lumière de la structure de support est formée dans une portion en relief de cette structure ;
- les moyens formant détecteur tactile sont reliés à des moyens électroniques d'analyse de commande de l'organe fonctionnel et de pilotage de la puissance de la source lumineuse.

L'invention sera mieux comprise à la lecture de la description qui va suivre, donnée uniquement à titre d'exemple et faite en se référant aux dessins annexés, sur lesquels :
- la Fig.1 représente une vue en coupe schématique illustrant la structure générale d'une pièce d'équipement selon l'invention ;
- la Fig.2 représente une vue en perspective éclatée d'une telle structure ;
- la Fig.3 représente une vue en coupe schématique illustrant la structure générale d'une variante de réalisation d'une pièce d'équipement selon l'invention ; et
- la Fig.4 représente une vue en perspective éclatée d'une telle structure.

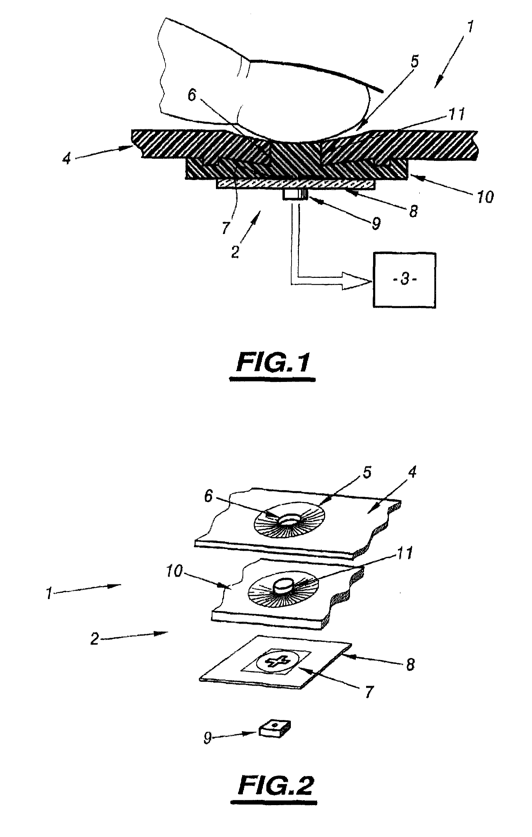

On a en effet représenté sur ces figures 1 et 2, une pièce d'équipement de véhicule automobile qui est désignée par la référence générale 1, et qui est équipée d'au moins un organe de commande désigné par la référence générale 2, d'un organe fonctionnel 3 de celui-ci.

Cette pièce d'équipement comporte une structure de support rigide désignée par la référence générale 4, munie d'une zone d'opération de commande désignée par la référence générale 5, matérialisée dans l'exemple décrit par une portion en creux de celle-ci.

Cette structure de support comporte au moins une lumière désignée par la référence générale 6, au niveau de cette zone d'opération 5.

De plus, cet organe de commande est muni d'au moins une cellule capacitive de détection tactile, désignée par la référence générale 7 sur cette figure, portée par exemple par une plaque de circuit imprimé translucide désignée par la référence générale 8, associée à une source lumineuse désignée par la référence générale 9.

Dans l'exemple décrit, la cellule capacitive de détection tactile 7 est fixée par exemple sur une face supérieure de la plaque de circuit imprimé 8, tandis que la source lumineuse est fixée sur l'autre face de celui-ci en regard de la cellule.

On notera que la face supérieure de cette plaque de circuit imprimé portant cette cellule, peut également être associée à un pictogramme matérialisant la fonction de commande remplie par cet organe, matérialisée dans l'exemple décrit par une croix.

D'autres modes de réalisation seront mentionnés par la suite.

Cet ensemble plaque de circuit imprimé, cellule de détection capacitive et source lumineuse, est disposé sur la face arrière d'une pièce intermédiaire désignée par la référence générale 10 sur ces figures, dont la face avant est fixée contre la structure 4 et comporte une partie en saillie 11 s'étendant à travers la lumière 6 de la structure de support pour faire légèrement saillie au-dessus de celle-ci dans la portion en creux de la zone d'opération.

Cette pièce 10 est réalisée par exemple en matière plastique déformable élastiquement et translucide.

Une telle structure permet alors d'assurer une protection de la cellule de détection capacitive contre les agressions extérieures mais également d'assurer un retour d'information tactile vers l'utilisateur lors de l'actionnement de l'organe de commande, car comme cela est illustré, lorsque l'utilisateur appuie sur la partie en saillie 11 de la pièce 10, celle-ci se déforme élastiquement.

La différence de texture entre cette partie en saillie 11 et le reste de la structure de support, permet également de faire percevoir à l'utilisateur cette notion de bouton de commande, ce qui a comme avantage de ne pas supprimer les repères tactiles de l'utilisateur qui a pour habitude de sentir la présence et le déplacement d'un bouton sous ses doigts.

Cette perception est cependant indépendante de la commande de l'organe qui n'est assurée qu'à partir des informations issues de la cellule de détection.

Comme cela a été indiqué précédemment, un pictogramme peut être associé à cet organe de commande pour matérialiser la fonction contrôlée par celui-ci.

Comme cela a été indiqué également, ce pictogramme peut être défini de différentes façons.

C'est ainsi par exemple que celui-ci peut être matérialisé par un masque porté par la plaque de circuit imprimé 8 sur l'une ou l'autre de ses faces ou encore par la pièce 10 sur l'une ou l'autre de ses faces, en regard de la lumière 6.

Ce pictogramme peut également être défini par la lumière 6 de la structure de support, qui présente alors une forme adaptée.

On conçoit alors que cette structure représente une solution simple et fiable d'intégration de l'organe de commande dans une pièce d'équipement de véhicule automobile, dans la mesure où l'organe de commande est parfaitement intégré à celui-ci et ne nécessite aucune pièce en mouvement.

La source lumineuse 9 assure un éclairage de cet organe, cette source pouvant être pilotée par exemple par des moyens électroniques associés à cet organe pour commander un changement de puissance lumineuse de la source lors de l'activation ou de la désactivation de l'organe.

Ceci permet alors à l'utilisateur d'avoir également un retour d'information lumineux concernant cette commande en plus du retour d'information tactile.

Bien entendu, d'autres modes de réalisation encore de ce système peuvent être envisagés.

Ainsi par exemple, l'organe de commande peut se présenter sous la forme d'un curseur.

La source lumineuse peut également être disposée de façon différente de celle décrite pour assurer un éclairage par exemple indirect de l'organe et plus particulièrement de la zone d'opération de celui-ci.

Enfin, le pictogramme associé à cet organe peut être matérialisé à côté de celui-ci et plus particulièrement de la zone d'opération.

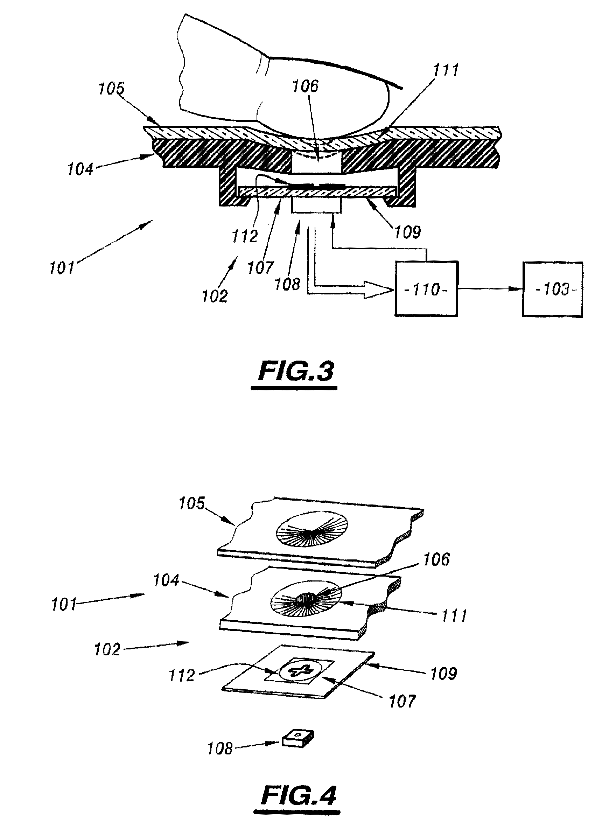

On a représenté sur les figures 3 et 4, une variante de réalisation d'une pièce d'équipement de véhicule automobile qui est désignée par la référence générale 101, et qui est équipée d'au moins un organe de commande désigné par la référence générale 102, d'un organe fonctionnel 103 de celui-ci.

Cette pièce d'équipement comporte une structure de support désignée par la référence générale 104 sur laquelle est disposée une peau de revêtement 105 souple et translucide.

La structure de support comporte au moins une lumière désignée par la référence générale 106, sous laquelle sont placés des moyens formant détecteur tactile désignés par la référence générale 107, et une source lumineuse désignée par la référence générale 108.

La peau peut recouvrir tout ou partie de la structure de support et s'étendre par exemple en partie dans la lumière 106 de celle-ci.

Les moyens formant détecteur tactile 107 sont par exemple portés par une plaque de circuit imprimé translucide, rigide ou souple, désignée par la référence générale 109 sur ces figures et la source lumineuse 108 est placée sous cette plaque de circuit imprimé. Cette source comporte par exemple une diode électroluminescente ou autre.

Ces moyens formant détecteur tactile et la source lumineuse sont maintenus en position par tous moyens de fixation classiques appropriés.

De façon classique, ces moyens formant détecteur tactile comprennent par exemple une électrode de détection de variation de capacité lorsque par exemple un utilisateur approche un doigt de celle-ci, pour délivrer une information qui est traitée par des moyens électroniques d'analyse désignés par la référence générale 110 sur la figure 3, afin de piloter l'organe fonctionnel 103 en conséquence.

Dans l'exemple de réalisation représenté sur ces figures, la lumière 106 de la structure de support est formée au fond d'une portion en creux 111 de celle-ci.

Un pictogramme peut être associé à cet organe de commande pour matérialiser la fonction contrôlée par celui-ci.

Ce pictogramme peut être défini de différentes façons.

C'est ainsi que la peau de revêtement 105 peut porter un masque matérialisant ce pictogramme associé à cette fonction, ce masque pouvant par exemple être formé sur la face supérieure ou sur la face inférieure de cette peau en regard de la lumière 106.

Ce pictogramme peut également être formé par un masque porté par la plaque de circuit imprimé 109 comme cela est illustré.

En effet, dans l'exemple décrit, la plaque de circuit imprimé 109 présente sur sa face supérieure, un masque désigné par la référence générale 112 matérialisant ce pictogramme.

Bien entendu, ce masque peut également être porté par la face inférieure de cette plaque.

Enfin, ce pictogramme peut également être défini par la lumière 106 de la structure de support qui présente alors une forme adaptée.

On conçoit que cette structure représente une solution simple et fiable, d'intégration de l'organe de commande dans une pièce d'équipement de véhicule automobile dans la mesure où l'organe de commande est parfaitement intégré à celui-ci et ne nécessite aucune pièce en mouvement.

La source lumineuse 108 assure un éclairage de cet organe, cette source pouvant être pilotée par exemple par les moyens électroniques d'analyse 110 pour commander un changement de puissance lumineuse de la source 108 lors de l'activation ou de la désactivation de l'organe.

Ceci permet alors à l'utilisateur d'avoir un retour d'information lumineux concernant cette commande.

L'utilisateur perçoit également un retour d'information tactile de commande lorsqu'il actionne un tel organe.

En effet, lorsque l'utilisateur appuie sur la zone de la structure de support en regard de cet organe de commande, il perçoit une sensation de déplacement de celle-ci en raison de la présence de la peau souple en regard de la lumière de la structure de support.

La zone d'opération de commande comporte en effet des moyens élastiquement déformables qui ont une position de repos dans laquelle le doigt de l'opérateur au contact de celle-ci est hors de l'espace de détection tactile et une position déformée dans laquelle le doigt de l'opérateur au contact de la zone d'opération est dans l'espace de détection tactile.

Bien entendu, d'autres modes de réalisation encore de ce système peuvent être envisagés.

Ainsi par exemple, l'organe de commande peut se présenter sous la forme d'un curseur.

Dans les exemples décrits, la zone d'opération est représentée sous la forme d'une portion en creux, mais il va de soi bien entendu que tout autre relief, par exemple sous la forme d'une bosse, peut être utilisé.

Enfin, le pictogramme associé à cet organe peut être matérialisé à côté de celui-ci.

## Revendications

1. Organe de commande de type capacitif pour la commande d'au moins un organe fonctionnel notamment de véhicule automobile, comprenant une structure de support rigide (4 ; 104), au moins une cellule capacitive de détection tactile (7 ; 107) localisée sur ou à proximité d'une des faces de ladite structure de support et au moins une zone (5 ; 111) d'opération de commande localisée sur ou à proximité de l'autre face de ladite structure de support (4 ;104) en regard de ladite cellule capacitive de détection tactile (7 ;107), **caractérisé en ce que** la zone d'opération de commande comprend des moyens (10,11 ;105) déformables élastiquement.

2. Organe de commande selon la revendication 1, **caractérisé en ce que** les moyens déformables (10,11) élastiquement sont indépendants de la commande de l'organe fonctionnel.

3. Organe de commande selon la revendication 1 ou 2, **caractérisé en ce que** les moyens (10,11) déformables élastiquement ont une position de repos dans laquelle le doigt de l'opérateur au contact de la zone d'opération est hors de l'espace de détection tactile et une position déformée dans laquelle le doigt de l'opérateur au contact de la zone d'opération est dans l'espace de détection tactile.

4. Organe de commande selon l'une quelconque des revendications précédentes, **caractérisé en ce que** les moyens déformables élastiquement sont formés par une partie en saillie (11) d'une pièce intermédiaire (10) en matériau déformable élastiquement, fixée sous la structure de support.

5. Organe de commande selon la revendication 4, **caractérisé en ce que** la structure de support rigide (104) porte une plaque de circuit imprimé sur laquelle sont fixées la cellule capacitive et une source lumineuse.

6. Organe de commande selon la revendication 4, **caractérisé en ce que** la pièce intermédiaire (10) porte une plaque de circuit imprimé sur laquelle sont fixées la cellule capacitive (7) et une source lumineuse.

7. Organe de commande selon l'une quelconque des revendications précédentes, **caractérisé en ce qu'**un masque matérialisant un pictogramme-associé à la fonction commandée par celui-ci, est associé à la pièce intermédiaire (10) ou à la plaque de circuit imprimé (8).

8. Organe de commande selon l'une quelconque des revendications précédentes, **caractérisé en ce que** la zone d'opération de commande est matérialisée par une portion en relief (5) de la structure de support.

9. Organe de commande selon l'une quelconque des revendications 5 ou 6 et 7 ou 8, **caractérisé en ce que** la pièce intermédiaire (10) et la plaque de circuit imprimé (8) sont en matériau translucide et **en ce que** la source lumineuse (9) est fixée sous la plaque de circuit imprimé.

10. Pièce d'équipement de véhicule automobile équipée d'au moins un organe de commande d'un organe fonctionnel selon l'une quelconque des revendications précédentes.

11. Pièce d'équipement selon la revendication 10, **caractérisée en ce qu'**elle comporte une structure de support (104) sur laquelle est disposée une peau de revêtement (105) souple et translucide et **en ce que** la structure de support comporte au moins une lumière (106) sous laquelle sont placés des moyens formant détecteur tactile (107) et une source lumineuse (108).

12. Pièce selon la revendication 11, **caractérisée en ce que** les moyens formant détecteur tactile (107) sont portés par une plaque de circuit imprimé translucide (109) sous laquelle est fixée la source lumineuse (108).

13. Pièce selon la revendication 11 ou 12, **caractérisée en ce que** la peau de revêtement (105) porte un masque matérialisant un pictogramme associé à la fonction commandée par l'organe.

14. Pièce selon la revendication 12, **caractérisée en ce que** le circuit imprimé porte un masque matérialisant un pictogramme associé à la fonction commandée par l'organe.

15. Pièce selon la revendication 11 ou 12, **caractérisée en ce que** la lumière (106) de la structure de support (104) présente une forme matérialisant un pictogramme associé à la fonction commandée par l'organe.

16. Pièce selon l'une quelconque des revendications 11 à 15, **caractérisée en ce que** la lumière (106) de la structure de support est formée dans une portion en relief (111) de cette structure (104).

17. Pièce selon l'une quelconque des revendications 11 à 16, **caractérisée en ce que** les moyens formant détecteur tactile sont reliés à des moyens électroniques d'analyse (110) de commande de l'organe fonctionnel et de pilotage de la puissance de la source lumineuse.
